# EUROPEAN PATENT SPECIFICATION

(11) **EP 0 282 734 B1**
(45) Date of publication and mention of the grant of the patent: **27.04.1994**
(21) Application number: 88101996.2
(22) Date of filing: 11.02.1988
(51) Int. Cl.: H01L 27/06

(54) **Integrated controlled power MOSFET**
Integrierter und kontrollierter Leistungs-MOSFET
MOSFET de puissance contrôlé intégré

(30) Priority: 13.02.1987 JP 29553/87
(43) Date of publication of application: 21.09.1988
(73) Proprietor: KABUSHIKI KAISHA TOSHIBA, Kawasaki-shi, Kanagawa-ken 210 (JP)
(72) Inventor: Takagi, Yosuke c/o Patent Division, Minato-ku Tokyo 105 (JP); Ohata, Yu c/o Patent Division, Minato-ku Tokyo 105 (JP); Kitahara, Koichi c/o Patent Division, Minato-ku Tokyo 105 (JP); Kuramoto, Tsuyoshi c/o Patent Division, Minato-ku Tokyo 105 (JP)
(74) Representative: Ritter und Edler von Fischern, Bernhard,Dipl.-Ing.

(56) References cited:
- ELECTRONIC DESIGN, no. 4, 21st February 1985, pages 191-196, Hasbruck Heights, New Jersey, US; W. SCHULTZ et al.: "Mixed MOS devices unite in a switch chip that links power with smarts"
- PATENT ABSTRACTS OF JAPAN, vol. 8, no. 53 (E-231)[1490], 9th March 1984 ; & JP-A-58 206 153
- IEEE SPECTRUM, no. 1, January 1985, pages 60-64, New York, US, "In smarter design and fabrication of IC s, power and logic are mixed on the same chip and circuits are integrated over an entire wafer"

## Description

The present invention relates to a semiconductor device comprising the features a) to c) of the preamble of claim 1 and 9, respectively.

Such a semiconductor device is disclosed in the Journal Electronic Design, No. 4, February 1985 on page 193. An epitaxial layer stacked upon a semiconductor substrate is subdivided by two p⁺⁺-buffer structures such that between said two buffer structures a first embedding area is formed that surrounds a source region and a gate region of a power TMOS-transistor. In said semiconductor substrate in a region below said first embedding area an n-plug serving as a drain is formed, which has a common boundary with said first embedding area. In a second embedding area of said epitaxial layer which is isolated from said first embedding area by one of the two buffer structures respective source regions, drain regions and gate regions of two n-channel and p-channel CMOS-transistors and a collector-, base- and emitter region of a bipolar transistor are formed. These CMOS-transistors and the bipolar transistor constitute a semiconductor control element for controlling said power TMOS-transistor. By contrast to providing the power-TMOS and the semiconductor control element separately, in which case the first and second embedding areas would be selectively adjusted to the characteristics of a power-transistor and a semiconductor control element, the fact of the first and second embedding areas being formed in the same epitaxial layer results in the disadvantage that a compromise has to be achieved such that the doping of the epitaxial layer partly suits the funtioning of the power-TMOS and partly suits the functioning characteristics of the semiconductor control element.

JP-A-58 206 153 discloses an arrangement of a static induction transistor SITL and a bipolar transistor on a common semiconductor substrate. In a layer stacked upon the semiconductor substrate a first embedding area provided for the individual elements of the static induction transistor is separated from a second embedding area by a buffer structure. In the first embedding area respective elements of the static induction transistor are formed, such as an injector, gates, a drain and a buried layer serving as a source of the SITL. On the other hand, a base, emitter and a buried collector region are formed in the second embedding area. The buried source of the SITL has stacked on the top and bottom thereof an additional layer to adjust the length of the current path between the buried source region and the drain. With such an arrangement the collector dielectric resistance of the bipolar transistor can be improved, without damaging the high-speed property of the SITL.

Page 61 in the Journal IEEE Spectrum, No. 1, January 1985 further discloses a semiconductor device comprising a power DMOS and a semiconductor control element, both integrated on a common semiconductor substrate. Two embedding areas separated by a buffer structure are provided in a layer stacked upon the semiconductor substrate. As in the above described first example, the individual elements for the power DMOS and for the semiconductor control element are respectively formed in these first and second embedding areas. However, since the first and second embedding areas are likewise formed of the same layer stacked upon the semiconductor substrate the power DMOS and the semiconductor control element have different characteristics in comparison when provided as separate elements on separate semiconductor substrates.

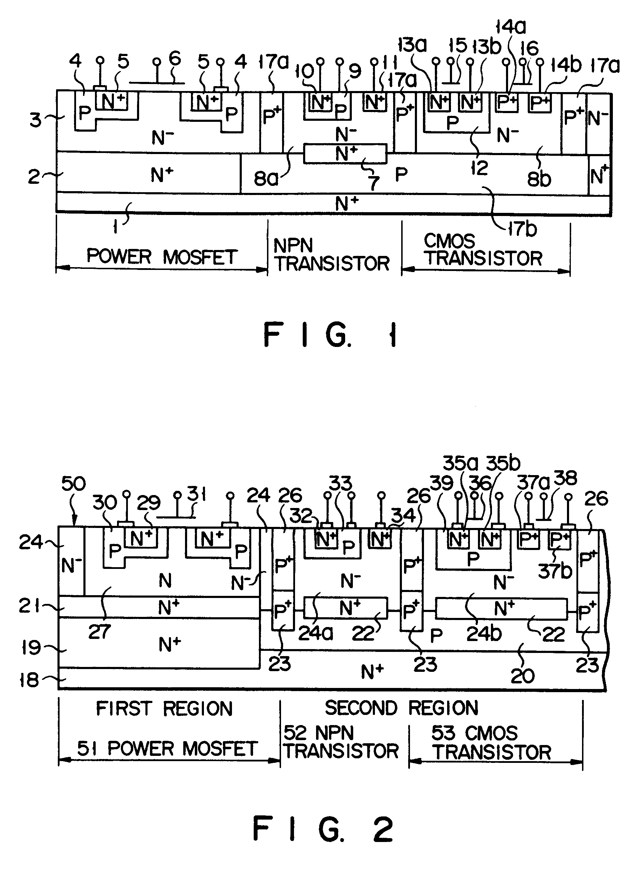

In the following, with reference to the attached figure 1, a detailed analysis of such a conventional form of semiconductor device will be given to further illustrate the underlying problems the present invention is concerned with. A composite semiconductor device is manufactured by monolithically integrating in a single semiconductor substrate a power MOSFET having a drain region of high resistance, a NPN-transistor and a MOS-transistor. Figure 1 is a cross-sectional view showing such a semiconductor device.

A power MOSFET will be explained below by way of example. The semiconductor device as shown in figure 1 includes N⁺ drain regions 1, 2 having a low resistance N⁻ by drain area 3 having a high resistance, P-type body 4, N⁺-type source region 5 and gate electrode 6.

Furthermore, a NPN-transistor will be explained in connection with a semiconductor device as shown in figure 1. The semiconductor device further includes N⁺-type collector regions 7 having a low resistance, N⁻-type collector area 8a having a high resistance, P-type base 9, N⁺-type emitter 10 and N⁺-type collector region from which a collector current is taken out for external connection.

A CMOS transistor will now be described below in connection with the semiconductor device shown in Fig. 1. The semiconductor device further includes the CMOS transistor having N⁻ type area 8b, P⁻ type well 12, N⁺ type drain region 13a and N⁺ type source region 13b of an N channel MOS FET within a P⁻ type well, gate electrode 15 of an N-channel type MOS FET, P⁺ type drain region 14a and P⁺ type source region 14b of an FET and gate electrode 16 of a P channel MOS FET. P⁺ type regions 17a and P type region 17b provide an electrical isolation, by a PN junction isolation method, among the Power MOS FET, NPN transistor and C-MOS transistor.

According to the conventional technique, drain area 3 having a high resistance in the Power MOS FET, N⁻ type collector area 8a having a high resistance in the NPN transistor and area 8b in the CMOS FET transistor are simultaneously formed in the semiconductor substrate by an epitaxial growth method. In this way, these regions have the same resistivity, but an optimum resistivity normally differs among the drain region of high resistance in the Power MOS FET, high resistance region in the NPN transistor, and so on. An optimum resistivity value of the drain region having a high resistance in the power MOS FET should be about 1 Ω·cm, for instance, at V_{DSS} = 60V where V_{DSS} represents a maximum drain-to-source voltage at the time of short-circuiting between the gate and source circuits of an associated transistor. On the other hand, an optimum resistivity value of the collector region having a high resistance in the NPN transistor should be about 6 Ω·cm, for instance, at V_{CEO} = 60V where V_{CEO} represents a maximum voltage between the collector and the emitter of an associated transistor with a base open-circuited. If the Power MOS FET and NPN transistor are integrated, as a Power-IC, in a single semiconductor substrate, when areas 3 and 8a are so formed as to have a resistivity value fitted for the NPN transistor, then the drain-to-source voltage V_{DSS} of the power MOS FET becomes greater than necessary with the result that the ON resistance per unit area becomes much greater. Thus the area of the power MOS FET necessary to obtain a desired ON resistance becomes much greater than that when an MOS FET is formed as a discrete part, so that there is involved a poor yield. Where areas 3 and 8a are formed with a resistivity value suitable for the Power MOS FET, restriction is imposed on the collector-to-emitter voltage V_{CED} of the NPN transistor, making it very difficult to achieve a circuit design involved.

If a semiconductor element and Power MOS FET having a drain region of high resistance are to be monolithically formed on a single semiconductor substrate, they are usually formed simultaneously, for example, by an epitaxial growth so that they have the same resistivity value. This resistivity value is properly selected in view of the characteristics of both the elements. In the conventional techniques it is very difficult to make the characteristics of the Power MOS FET within the aforementioned composite semiconductor device, such as the ON resistance and withstand voltage, equal to those of the Power MOS FET manufactured as a discrete element.

This type of composite semiconductor has extensively employed in a quickly expanding application field and there is also a wider demand for the characteristics of elements integrated. It is very important to optimally design integrated elements as mutually independent, discrete ones.

Accordingly, the object of the present invention is to provide a semiconductor device having monolithically integrated a power insulated-gate type field effect transistor and a semiconductor control element on a single semiconductor device, such that the individual integrated elements possess characteristics which are equal to those of such elements formed as discrete elements.

The above object is solved by a semiconductor device comprising the features of claims 1 and 9, respectively. The inventive semiconductor devices comprise first and second embedding areas which are individually and selectively processed and formed onto a semiconductor substrate, allowing a selective adjustment of resistivity values for the power transistor and the semiconductor control element, respectively. Since the first and second embedding areas are not formed from a common layer, their resistivity values can differ and can be selectively adjusted independently from each other such that they are best suited to the performance of each individual element.

In the composite semiconductor device of the present invention the resistivity value of the first area of the power MOS FET, i.e., the drain region of high resistivity and that of a second area, i.e., a control element can be made fitted for element formation. The characteristics of respective elements thus integrated can be made equal to those of elements which are formed as discrete elements. The aforementioned feature of the present invention can improve a problem, such as an increase in the ON resistance in particular of the Power MOS FET, which occurs due to the same resistivity involved between a power MOS FET section and a control element section in the conventional composite semiconductor device. Since the area of the Power MOS FET section can be made smaller than that of the conventional semiconductor device, it is thus possible to form semiconductor elements at a low cost in high yield.
Fig. 1 is a cross-sectional view showing a conventional semiconductor device;
Fig. 2 is a cross-sectional view showing a semiconductor device according to one embodiment of the present invention;
Fig. 3(a) to Fig. 3(f) show a process of manufacturing a semiconductor device shown in Fig. 2;
Fig. 4 is a cross-sectional view showing a semiconductor device according to another embodiment of the present invention;
Fig. 5(a) and Fig. 5(b) are cross-sectional views showing another embodiment of the present invention;
Fig. 6(a) and Fig. 6(b) are cross-sectional views showing a semiconductor device according to another embodiment of the present invention;
Fig. 7(a) and Fig. 7(b) are cross-sectional views showing a semiconductor device according to another embodiment of the present invention;
Fig. 8(a) to Fig. 8(f) are cross-sectional views showing a semiconductor device according to another embodiment of the present invention;
Fig. 9 is a cross-sectional view showing a semiconductor device according to another embodiment of the present invention; and
Fig. 10(a) to Fig. 10(c) are cross-sectional views showing a semiconductor device according to another embodiment of the present invention.

The embodiments of the present invention will now be explained below with reference to the accompanying drawings.

Fig. 2 is a cross-sectional view showing a semiconductor device according to a first embodiment of the present invention. Power MOS FET 51, NPN transistor 52 and CMOS transistor 53 used for controlling MOS FET 51 are all integrated in semiconductor substrate 50. Power MOS FET 51 is comprised of high resistance area 27 (first area), a drain region comprised of low resistance regions 18, 19 and 21, P type body 30, and gate electrode 31. NPN transistor 52 used for controlling MOS FET 51 is formed within high resistance N⁻ type area 24a (second area) and comprised of emitter 32, P type base 33, and N⁺ type collector 34. Reference numeral 22 is an N⁺ type collector, which serves to lower the collector resistance. CMOS transistor 53 is formed within N⁻ type area 24b (second area) and comprises an N-channel MOS FET; which includes N⁺ type drain 35a, N⁺ type source 35b, and gate electrode 36 formed within P type well 39, and P-channel MOS FET; which includes P⁺ type drain 37a, P⁺ type source 37b, and gate electrode 38 formed within N⁻ type area 24b. Power MOS FET 51, NPN transistor 52, and MOS transistor 53 are electrically isolated by P type layer 20 and P⁺ type layers 23 and 26 (element isolation layers). In the embodiment shown in Fig. 2, a high resistance drain area (first area) in the Power MOS FET has a resistivity value of about 1 Ω·cm and the substrate area (second area) corresponding to control transistor elements has a resistivity value of 5 to 7 Ω·cm, these values being properly set in the formation of transistor elements.

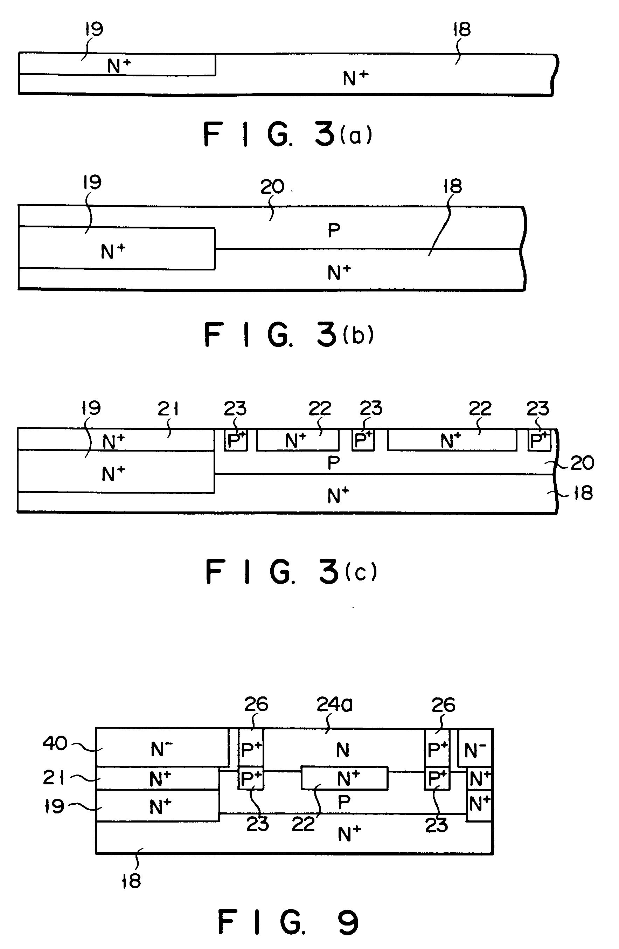

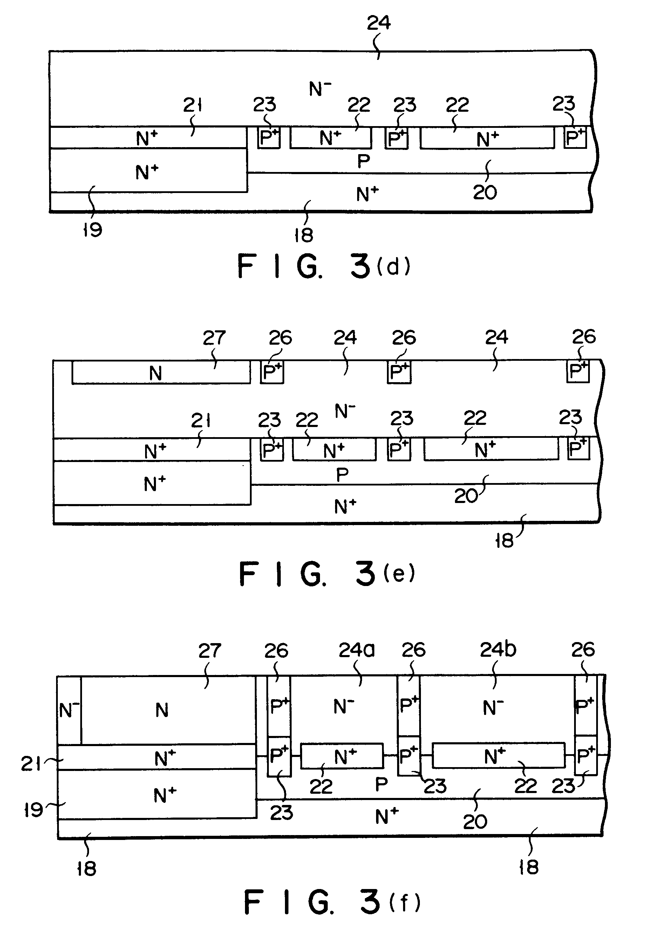

Fig. 3(a) to Fig. 3(f) are cross-sectional views showing a principal process in manufacturing the aforementioned semiconductor device of the present invention. N⁺ type silicon substrate 18 of low resistance is prepared with a highly-concentrated antimony doped therein. A highly-concentrated phosphorus is diffused in a low-resistance drain formation section of a Power MOS FET in a gaseous atmosphere of N₂ and O₂ at 1000° to 1100°C for 30 to 120 minutes to form N⁺ type region 19 as shown in Fig. 3(a). P type silicon of 7 to 10 Ω (resistivity) is epitaxially grown on the surface of the resultant structure to form a P type silicon layer (element isolation layer) about 20 or 30 µm in thickness and then thermally diffused in a gaseous atmosphere of N₂ and O₂ at 1100° to 1200°C for 12 to 13 hours to form N⁺ type region 19 as shown in Fig. 3(b). Antimony is diffused in the portion of the resultant structure in a gaseous atmosphere of N₂ at 1100°C to 1200°C for 20 to 120 minutes to form N⁺ type region 21, corresponding to a low-resistance drain region in the Power MOS FET as well as low-resistance area 22 used as a controlling element. A P⁺ type impurity (boron) is diffused for 30 minutes in an element isolation area of a formation portion with a gaseous atmosphere of 1000°C to 1100°C to form element isolation P⁺ type layer 23, as shown in Fig. 3(c). Then N⁻ type silicon layer 24 (phosphorus) is epitaxially grown on the resultant structure so as to have a desired resistivity value and thickness, as shown in Fig. 3(d). In the embodiment of the present invention, an N⁻ type silicon layer (second layer) is formed which has a resistivity value of 5 to 7 Ω·cm and a thickness of 17 to 20 µm, suitable to the formation of the NPN transistor used for controlling POWER MOS FET. Then a phosphorus ion and an impurity concentration of 1 × 10¹² to 1 × 10¹³ cm⁻² used to form N type silicon area 27 are injected into the Power MOS FET formation section at an acceleration voltage of 100 keV. A P⁺ type impurity (boron) is diffused for four hours into an element isolation area of a formation portion with a gaseous atmosphere of N₂ at 1000° to 1100°C to form element isolation p⁺ type layer 26, as shown in Fig. 3(e). The thermal diffusion is achieved in a gaseous atmosphere of N₂ and O₂ at 1100° to 1200°C for 8 hours, so that element isolation P⁺ layer 26 reaches element isolation P⁺ type layer 23. In this way, island areas 24a, 24b are formed such that they are surrounded with P⁺ and P type silicon layers, that is, element isolation P⁺ type layers 23 and 26. At this time, N type silicon area 27 extends in the depth direction, as shown in Fig. 3(f). Island areas 24a and 24b are formed as second areas of the controlling element in the substrate, and N type silicon area 27 is formed as a high resistance drain area (first area) in the Power MOS FET. In this embodiment, the phosphorus concentration and diffusion time are so selected as to be about 1 Ω·cm, a value suitable to the Power MOS FET at V_{DSS} = 60V. In this way, the Power MOS FET is formed at area 27 and the NPN transistor (control) and the CMOS transistor are formed at areas 24a and 24b, respectively, as shown in Fig. 2.

In the first embodiment, epitaxial layer 24 which has a resistive value suitable to the formation of NPN transistor (control), is deposited as shown in Fig. 3(d), noting that second areas 24a, 24b are formed in epitaxial layer 24. Area 27 (first area) of Power MOS FET in epitaxial layer 24 is set to have a proper resistivity value by means of an impurity diffusion method, as shown in Fig. (e) and Fig. (f).

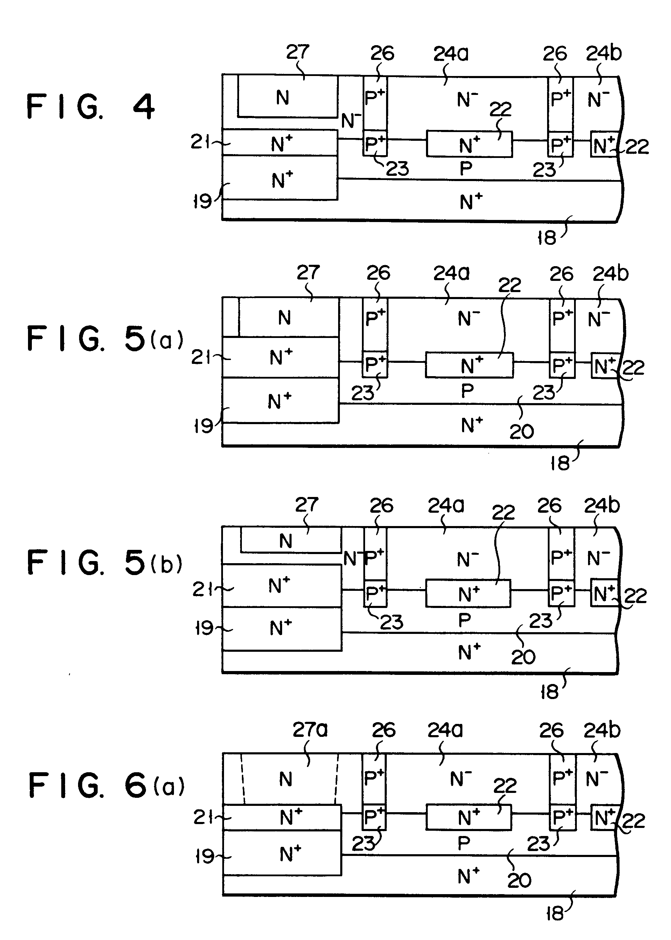

Fig. 4 is a cross-sectional view showing a semiconductor device according to a second embodiment of the present invention. In the first embodiment, N type silicon 27 (first area) reaches low resistance drain region 21 while, in the second embodiment, first area 27 may be of such a type that it does not reach region 21 in which case thermal diffusion is performed in a shorter time than in the first embodiment, as shown in Fig. 4, for example, for 5 hours in a gaseous atmosphere of N₂ and O₂ at 1100° to 1200°C.

Fig. 5(a) and Fig. 5(b) are cross-sectional views showing a semiconductor device according to a third embodiment of the present invention. In the third embodiment, phosphorus is doped into a semiconductor structure to form low resistance drain region 21 in a Power MOS FET and antimony is dopes as an impurity in low resistance collector region 22 in which case, due to a difference in the diffusion coefficient between the phosphorus and antimony, N type silicon area 27 is made to be more shallow than second area 24a. In Fig. 5(a), area 27 is of such a type that it reaches low resistance drain region 21 and, in Fig. 5(b), region 27 does not reach drain region 21.

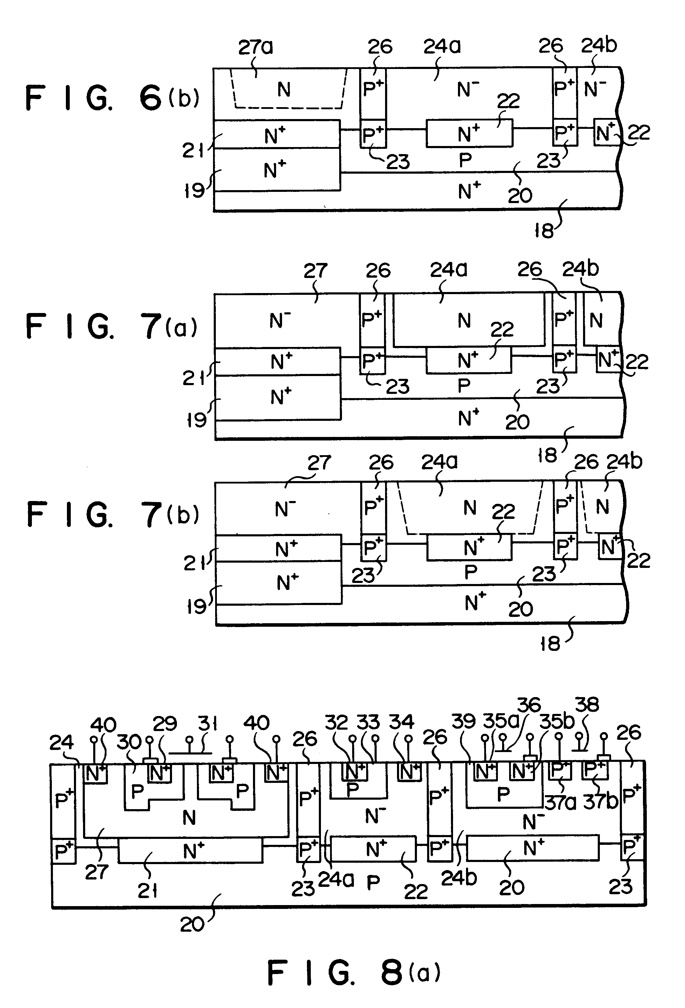

Fig. 6(a) and Fig. 6(b) are cross-sectional views showing a semiconductor device according to a fourth embodiment of the present invention. In the fourth embodiment, an area including a Power MOS FET is etched to a desired depth.

N type silicon of a desired resistivity value is epitaxially grown onto that etched section to form N type silicon area 27a, at which time the surface of the resultant structure is planarized.

In Fig. 6(a), region 27a is of such a type that it reaches drain region 21 of low resistivity and, in Fig. 6(b), region 27a does not reach drain region 21.

Fig. 7(a) and Fig. 7(b) show a second embodiment according to a fifth embodiment of the present invention. Although in the aforementioned embodiments the drain area of low resistance has been explained as having a varying resistivity value, it is also possible to vary the resistivity value of area 24a in a control element section as the case may be. In Fig. 7(a), control element formation area (second area) 24a is so formed through impurity diffusion as to be made different in resistivity from a Power MOS FET formation area. In Fig. 7(b), the second area is selectively etched in the semiconductor structure and a layer is epitaxially grown on the corresponding area of the semiconductor structure so as to be made different in resistivity from the Power MOS FET formation area.

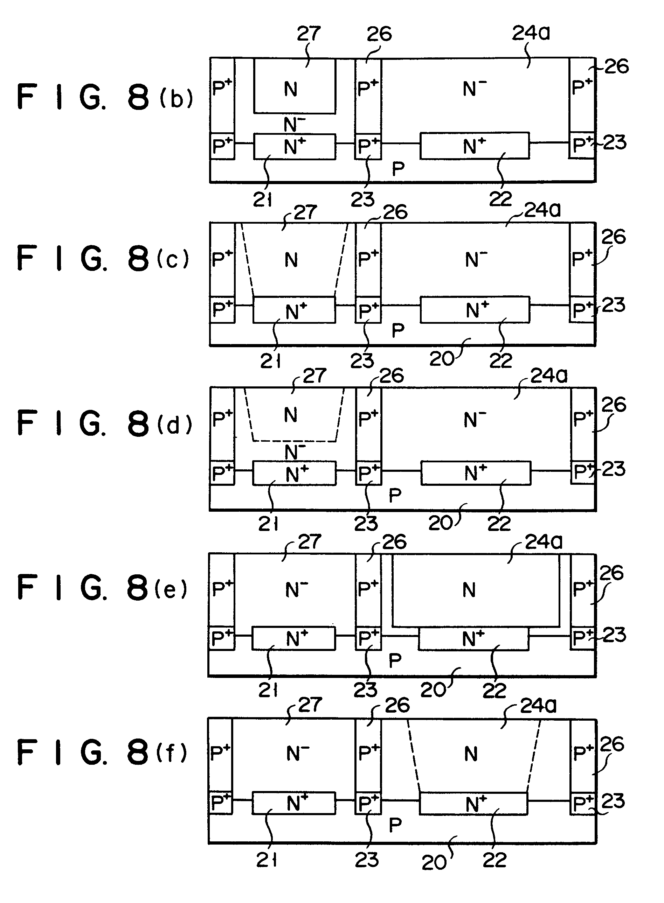

Fig. 8(a) to Fig. 8(f) are cross-sectional views showing a semiconductor device according to a sixth embodiment of the present invention. In connection with the first to fifth embodiments, an explanation has been made of the semiconductor device in which a source current of a Power MOS FET is taken out from a first major surface side (the upper surface side) of the semiconductor substrate and a drain current from a second major surface side (the lower surface side) of the semiconductor substrate.

In the embodiment shown in Fig. 8(a) to Fig. 8(f), source and drain currents of the Power MOS FET are taken from the first major surface side of the semiconductor substrate. In the embodiment shown in Fig. 8 similar reference numerals are employed to designate parts or elements corresponding to those shown in the embodiment of Fig. 2. Reference numeral 40 shows an N⁺ drain region for taking out a drain current of the Power MOS FET. The semiconductor device is of such a type that the drain area (first area) of high resistivity is so formed as to be made different in resistance from control element formation area (24a, 24b) and that area 27 reaches the drain region of low resistance. Fig. 8(b) shows a modified form of semiconductor device in which the first area is so formed through impurity diffusion as to be made different in resistivity from areas 24a, 24b and that the first area does not reach drain region 21 of low resistivity. Fig. 8(c) shows a semiconductor device in which, after the etching of the first area, a layer is epitaxially grown on the surface of the resultant semiconductor structure such that it reaches drain region 21 of low resistance with the former made different in resistivity from the latter. Fig. 8(d) shows a form of semiconductor device in which after the etching of the first area a layer is epitaxially grown on the surface of the resultant structure such that it does not reach the drain region of low resistance. Fig. 8(e) shows a semiconductor device in which a second region is so formed through impurity diffusion as to vary its resistivity value and Fig. 8(f) shows a semiconductor device in which a second area varies its resistivity value by an etching step and epitaxially growing step. Although, in order to make the first and second areas different in resistivity from each other, the N⁻ type are of high resistance having a lower impurity concentration is converted to the N type area of high impurity concentration in the aforementioned embodiments, the N type area may be changed to the N⁻ type area either by varying their resistivity values through the diffusion of an impurity of the opposite conductivity type or by etching the N type area and epitaxially growing an N⁻ type silicon layer of a lower impurity concentration.

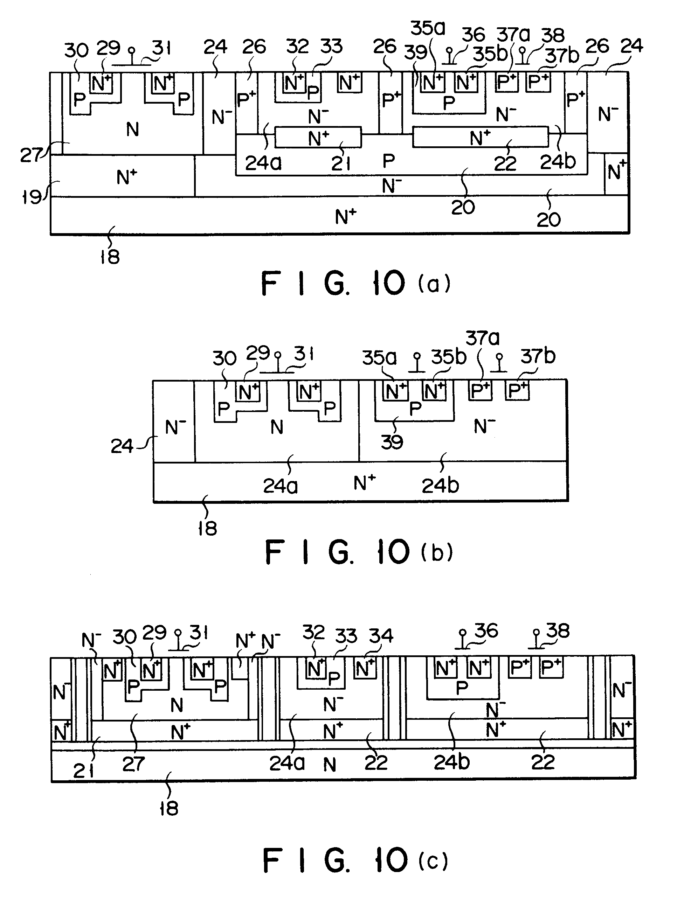

Fig. 9 is a cross-sectional view showing a semiconductor device according to a seventh embodiment of the present invention. In the seventh embodiment, after the formation of N type epitaxial layer 24 (see Fig. 3), an impurity (boron) of the other conductivity type is diffused into area 27 in a Power MOS FET to form N type area 27 as N⁻ type region 40.

The present invention can also be applied to Power MOS FET in another element isolation structure.

Fig. 10(a) to Fig. 10(c) show additional semiconductor devices according to the present invention, that is, a device fabricated by a PN isolation method, device fabricated by a self isolation method and device fabricated by a dielectric isolation method, respectively.

## Claims

1. A semiconductor device including
a) a first portion constituting a power insulated-gate type field effect transistor (FET) (51) having a drain region (18,19,21), a source region (29,30), a gate region (31) and a first embedding area (27) surrounding said source region (29,30) and said gate region (31); and
b) a second portion constituting a semiconductor control element (52,53) for controlling said power FET (51), comprising
a bipolar transistor (52) having a collector region (34), a base region (33) and an emitter region (32);
a CMOS-transistor having source regions (35b,37b), drain regions (35a,37a), and gate regions (36,38); and
a second embedding area (24a,24b) surrounding said collector-, base- and emitter regions (34, 33,32) and said source-, drain- and gate regions (35a,35b;37a,37b;36,38), respectively; whereby
c) said first and second portions are formed on a common semiconductor substrate (50);
**characterized** in that,
d) said first embedding area (27) of said power FET (51) in said first portion and said second embedding area (24a,24b) of said semiconductor control element in said second portion possess different values of resistivity.

2. A semiconductor device according to claim 1, characterized in that said first embedding area (27) of said power insulated-gate type field effect transistor of said first portion (51) has a lower resistivity value than said second embedding area (24a,24b) of said semiconductor control element (52,53) in said second portion.

3. A semiconductor device according to claim 1, characterized in that said drain region (18,19,21) and said first embedding area (27) of said power insulated-gate type field effect transistor (51) possess different values of resistivity.

4. A semiconductor device according to claim 3, characterized in that said drain region (18,19,21) has a lower resistivity value than said first embedding area (27).

5. A semiconductor device according to claim 1, characterized in that said drain region (18,19,21) of said power insulated-gate type field effect transistor (51) comprise three regions (18,19,21) stacked onto each other having the same type of impurity doping (N⁺).

6. A semiconductor device according to claim 1, characterized in that said drain region (18,19,21) of said power insulated-gate type field effect transistor (51) and said first embedding area (27) are arranged such that they comprise a common boundary.

7. A semiconductor device according to claim 1, characterized in that said drain region (18,19,21) of said power insulated-gate type field effect transistor (51) and said first embedding area (27) have interposed therebetween another region of the same conductivity type as said drain region (18,19,21).

8. A semiconductor device according to claim 1, characterized in that said second embedding area (24a,24b) of said semiconductor control element (52,53) and said drain region (18,19,21) of said power insulated-gate type field effect transistor (51) and said first embedding area (27) are impurity-diffused regions.

9. A semiconductor device including
a) a first portion constituting a power insulated-gate type field effect transistor (51) having a drain region (18,19,21), a source region (29,30) a gate region (31) and a first embedding area (27) surrounding said source region (29,30) and said gate region (31); and
b) a second portion constituting a semiconductor control element (52,53) for controlling said power insulated-gate type field effect transistor (51), said semiconductor control element being formed in a second embedding area (24a, 24b); whereby
c) said first and second portions are formed on a common semiconductor substrate (50);
characterized in that
d) said first embedding area (27) of said power insulated-gate type field effect transistor (51) in said first portion and said second embedding area (24a,24b) of said semiconductor control element (52,53) in said second portion possess different resistivity values, respectively.

## Patentansprüche

1. Halbleitervorrichtung mit:
a) einem ersten Abschnitt, darstellend einen Leistungsfeldeffekttransistor mit isoliertem Gate (FET) (51) mit einem Drainbereich (18, 19, 21), einem Sourcebereich (29, 30), einem Gatebereich (31) und einem ersten Einbettungsbereich (27) umrundend den Sourcebereich (29, 30) und den Gatebereich (31); und
b) einem zweiten Abschnitt, darstellend ein Halbleitersteuerelement (52, 53) zum Steuern des LeistungsFET (51), welcher umfaßt:
einen bipolaren Transistor (52) mit einem Kollektor (34), einem Basisbereich (33) und einem Emitterbereich (32);
einen CMOS-Transistor mit Sourcebereichen (35b, 37b), Drainbereichen (35a, 37a) und Gatebereichen (36, 38); und
einen zweiten Einbettungsbereich (24a, 24b) umgebend die Kollektor-, Basis- und Emitterbereiche (34, 33, 32) bzw. die Source-, Drain- und Gatebereiche (35, 35b; 37a, 37b; 36, 38); wobei
c) die ersten und zweiten Abschnitte gebildet sind auf einem gemeinsamen Halbleitersubstrat (50);
dadurch **gekennzeichnet**, daß
d) der erste Einbettungsbereich (27) des Leistungs-FET (51) in dem ersten Abschnitt und der zweite Einbettungsbereich (24a, 24b) des Halbleitersteuerelements in dem zweiten Abschnitt verschiedene Werte des Widerstands besitzen.

2. Halbleitervorrichtung nach Anspruch 1, dadurch gekennzeichnet, daß der erste Einbettungbereich 27 des Leistungsfeldeffekttransistors mit isoliertem Gate des ersten Abschnitts (51) einen niedrigeren Widerstandswert als der zweite Einbettungsbereich (24a, 24b) des Halbleitersteuerelements (52, 53) im zweiten Abschnitt hat.

3. Halbleitervorrichtung nach Anspruch 1, dadurch gekennzeichnet, daß der Drainbereich (18, 19, 21) und der erste Einbettungsbereich (27) des Leistungsfeldeffekttransistors mit isoliertem Gate (51) verschiedene Werte des Widerstandes besitzen.

4. Halbleitervorrichtung nach Anspruch 3, dadurch gekennzeichnet, daß der Drainbereich (18, 19, 21) einen niedrigeren Widerstandsbereich als der erste Einbettungsbereich (27) hat.

5. Halbleitervorrichtung nach Anspruch 1, dadurch gekennzeichnet, daß der Drainbereich (18, 19, 21) des Leistungsfeldeffekttransistors mit isoliertem Gate (51) drei Bereiche (18, 19, 21), aufeinandergestapelt mit dem gleichen Typ von Verunreinigungsdotierung (N⁺), umfaßt.

6. Halbleitervorrichtung nach Anspruch 1, dadurch gekennzeichnet, daß der Drainbereich (18, 19, 21) des Leistungsfeldekffekttransistors mit isoliertem Gate (51) und dem ersten Einbettungsbereich (27) so angeordnet sind, daß sie eine gemeinsame Grenze umfassen.

7. Halbleitervorrichtung nach Anspruch 1, dadurch gekennzeichnet, daß der Drainbereich (18, 19, 21) des Leistungsfeldeffekttransistors mit isoliertem Gate (51) und der erste Einbettungsbereich (27) einen weiteren Bereich desselben Leitungstyps wie dem Drainbereich (18, 19, 21) zwischengelagert haben.

8. Halbleitervorrichtung nach Anspruch 1, dadurch gekennzeichnet, daß der zweite Einbettungsbereich (24a, 24b) des Halbleitersteuerelements (52, 53) und der Drainbereich (18, 19, 21) des Leistungsfeldeffekttransistors mit isoliertem Gate (51) und der erste Einbettungsbereich (27) verunreinigungsdiffundierte Bereiche sind.

9. Halbleitervorrichtung mit:
a) einem ersten Abschnitt, darstellend einen Leistungsfeldeffekttransistor mit isoliertem Gate (51) mit einem Drainbereich (18, 19, 21), einem Sourcebereich (29, 30), einem Gatebereich (31) und einem ersten Einbettungsbereich (27), umgebend den Sourcebereich (29, 30) und den Gatebereich (31); und
b) einem zweiten Abschnitt, darstellend ein Halbleitersteuerelement (52, 53) zum Steuern des Leistungsfeldeffekttransistors mit isoliertem Gate (51), wobei das Halbleitersteuerelement gebildet ist in einem zweiten Einbettungsbereich (24a, 24b); wobei
c) die ersten und zweiten Abschnitte gebildet sind auf einem gemeinsamen Halbleitersubstrat (50);
dadurch **gekennzeichnet**, daß
d) der erste Einbettungsbereich (27) des Leistungsfeldeffekttransistors mit isoliertem Gate (51) in dem ersten Abschnitt und der zweite Einbettungsbereich (24a, 24b) des Halbleitersteuerelements (52, 53) in dem zweiten Abschnitt verschiedene Widerstandswerte besitzen.

## Revendications

1. Dispositif à semiconducteur incluant :
a) une première partie constituant un transistor à effet de champ (FET) de puissance du type à grille isolée (51) comportant une région de drain (18, 19, 21), une région de source (29, 30), une région de grille (31) et une première zone d'enterrement (27) entourant ladite région de source (29, 30) et ladite région de grille (31) ; et
b) une seconde partie constituant un élément de commande à semiconducteur (52, 53) pour commander ledit FET de puissance (51), comprenant :
un transistor bipolaire (52) comportant une région de collecteur (34), une région de base (33) et une région d'émetteur (32) ;
un transistor CMOS comportant des régions de source (35b, 37b), des régions de drain (35a, 37a) et des régions de grille (36, 38) ; et
une seconde zone d'enterrement (24a, 24b) entourant respectivement lesdites régions de collecteur, de base et d'émetteur (34, 33, 32) et lesdites régions de source, de drain et de grille (35a, 35b ; 37a, 37b ; 36, 38) et ainsi,
c) lesdites première et seconde parties sont formées sur un substrat semiconducteur commun (50),
caractérisé en ce que :
d) ladite première zone d'enterrement (27) dudit FET de puissance (51) situé dans ladite première partie et ladite seconde zone d'enterrement (24a, 24b) dudit élément de commande à semiconducteur situé dans ladite seconde partie possèdent des valeurs de résistivité différentes.

2. Dispositif à semiconducteur selon la revendication 1, caractérisé en ce que ladite première zone d'enterrement (27) dudit transistor à effet de champ de puissance du type à grille isolée de ladite première partie (51) présente une valeur de résistivité inférieure à celle de ladite seconde zone d'enterrement (24a, 24b) dudit élément de commande à semiconducteur (52, 53) situé dans ladite seconde partie.

3. Dispositif à semiconducteur selon la revendication 1, caractérisé en ce que ladite région de drain (18, 19, 21) et ladite première zone d'enterrement (27) dudit transistor à effet de champ de puissance du type à grille isolée (51) possèdent des valeurs de résistivité différentes.

4. Dispositif à semiconducteur selon la revendication 3, caractérisé en ce que ladite région de drain (18, 19, 21) présente une valeur de résistivité inférieure à celle de ladite première zone d'enterrement (27).

5. Dispositif à semiconducteur selon la revendication 1, caractérisé en ce que ladite région de drain (18, 19, 21) dudit transistor à effet de champ de puissance du type a grille isolée (51) comprend trois régions (18, 19, 21) empilées les unes sur les autres, lesquelles présentent le même type de dopant d'impuretés (N⁺).

6. Dispositif à semiconducteur selon la revendication 1, caractérisé en ce que ladite région de drain (18, 19, 21) dudit transistor à effet de champ de puissance du type à grille isolée (51) et ladite première zone d'enterrement (27) sont agencées de telle sorte qu'elles comprennent une frontière commune.

7. Dispositif à semiconducteur selon la revendication 1, caractérisé en ce que ladite région de drain (18, 19, 21) dudit transistor à effet de champ de puissance du type à grille isolée (51) et ladite première zone d'enterrement (27) se voient interposer entre elles une autre région du même type de conductivité que ladite région de drain (18, 19, 21).

8. Dispositif à semiconducteur selon la revendication 1, caractérisé en ce que ladite seconde zone d'enterrement (24a, 24b) dudit élément de commande à semiconducteur (52, 53) et de ladite région de drain (18, 19, 21) dudit transistor à effet de champ de puissance du type à grille isolée (51) et ladite première zone d'enterrement (27) sont des régions à impuretés diffusées.

9. Dispositif à semiconducteur incluant :
a) une première partie constituant un transistor à effet de champ de puissance du type à grille isolée (51) comportant une région de drain (18, 19, 21), une région de source (29, 30), une région de grille (31) et une première zone d'enterrement (27) entourant ladite région de source (29, 30) et ladite région de grille (31) ; et
b) une seconde partie constituant un élément de commande à semiconducteur (52, 53) pour commander ledit transistor à effet de champ de puissance du type à grille isolée (51), ledit élément de commande à semiconducteur étant formé dans une seconde zone d'enterrement (24a, 24b) et ainsi,
c) lesdites première et seconde parties sont formées sur un substrat semiconducteur commun (50),
caractérisé en ce que :
d) ladite première zone d'enterrement (27) dudit transistor à effet de champ de puissance du type à grille isolée (51) situé dans ladite première partie et ladite zone d'enterrement (24a, 24b) dudit élément de commande à semiconducteur (52, 53) situé dans ladite seconde partie possèdent respectivement des valeurs de résistivité différentes.
